# EUROPEAN PATENT APPLICATION

(11) **EP 1 841 061 A2**
(43) Date of publication of application: **03.10.2007**
(21) Application number: 07006757.4
(22) Date of filing: 30.03.2007
(51) Int. Cl.: H03G 3/30

(54) **Gain control method and apparatus in receiver of wireless communication system**

(30) Priority: 30.03.2006 KR 20060028903
(71) Applicant: Samsung Electronics Co., Ltd., Suwon-si, Gyeonggi-Do (KR)
(72) Inventor: Yu, Hyun-Seok, Suwon-si Gyeonggi-do (KR); Park, Hung-Su, Suwon-si Gyeonggi-do (KR); Oh, Hyun-Seok, Suwon-si Gyeonggi-do (KR)
(74) Representative: Grünecker, Kinkeldey, Stockmair & Schwanhäusser Anwaltssozietät

(57) **Abstract**

Provided is a method and apparatus for controlling a gain of a receiver in a wireless communication system. The method of controlling a gain of a received signal in a receiver using a Low Noise Amplifier (LNA) and a Variable Gain Amplifier (VGA) includes respectively generating first gain control signals for the LNA and the VGA based on a signal received via an antenna and digitized by the LNA and the VGA, measuring a power detection value from power of a low-noise-amplified signal by the LNA, determining offsets for controlling increase and decrease of the first gain control signals based on the power detection value of the LNA output, and respectively providing second gain control signals obtained by adding the offsets to the first gain control signals to the LNA and the VGA.

## Description

### BACKGROUND OF THE INVENTION

### 1. Field of the Invention

The present invention relates generally to a wireless transmission and reception system, and, in particular, to a gain control method and apparatus for preventing saturation of an analog amplifier using reception signal information in a modem.

### 2. Description of the Related Art

Radio Frequency (RF) technology allows for coverage of a wide dynamic range and RF component control technology in wireless communication systems, much research of RF technology and RF control technology has been being performed.

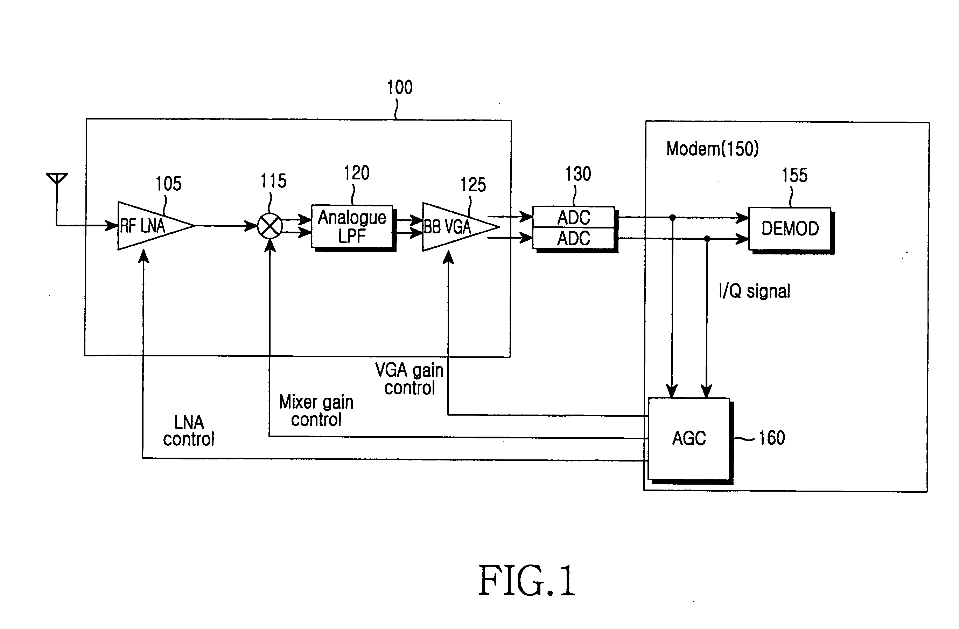

FIG 1 is a block diagram of a conventional receiver system

Referring to FIG 1, RF tuner 100 of conventional receiver includes an antenna, an RF Low Noise Amplifier (LNA) 105, a mixer 115, a Low Pass Filter (LPF) or Band Pass Filter (BPF) 120, and a Base-Band Variable Gain Amplifier (BB-VGA) 125, and, in some cases, the mixer 115 down-converts a received RF signal to a base-band or Intermediate Frequency (IF) signal.

An electromotive force induced by a signal received via the antenna is amplified by the RF LNA 105, and the amplified signal is down-converted by the mixer 115. The RF LNA 105 and the mixer 115 can select one of several gains in most cases, and a base-band modem 150 generally controls the gains.

A gain control operation of the modem 150 will now be described. If a signal output from the BB VGA 125 is input as In-phase/Quadrature-phase (I/Q) signals digital-converted by an Analog-to-Digital Converter (ADC) 130, the I/Q signals are demodulated by a demodulator 155 and simultaneously input to an Automatic Gain Controller (AGC) 160. The AGC 160 generates an LNA gain control signal, a mixer gain control signal, and a VGA gain control signal based on the I/Q signals. The gain control is performed by inputting the respective gain control signals to the RF LNA 105, the mixer 115, and the BB VGA 125.

The gain controlled signal passes through the LPF 120 if it is a zero-IF signal or the BPF 120 if it is a heterodyne signal. The BB VGA 125 more finely controls a gain approximately controlled by the RF LNA 105 and the mixer 115.

That is, analog components for controlling a gain in the RF tuner 100 are the RF LNA 105, the mixer 115, and the BB VGA 125 in most cases. Some of these three analog components or an additional amplifier may be used in some cases.

The fundamental reason to control a gain using several amplification components is because there is limitation in a dynamic range in which a signal is linearly amplified using a single amplifier. This problem can be solved by using several amplifiers connected in series. Since the mixer 115 has a fixed gain without controlling the gain in most cases, only the RF LNA 105 and the BB VGA 125 will be dealt with hereinafter.

Although there exist many methods tocontroll gain of amplification components, it is assumed that a method used in conventional mobile communication terminal is used. In a conventional RF tuner structure, amplification is performed in a position closer to an antenna if possible in order to minimize a Noise Figure (NF).

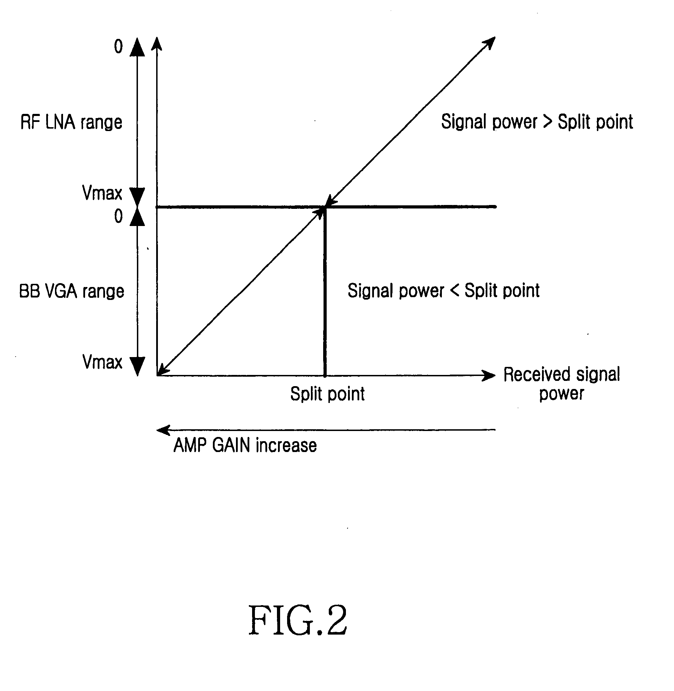

FIG 2 is a graph showing linear gain control of a conventional RF/BB amplifier.

FIG 2 shows the principle of linear gain control. Referring to FIG 2, in order to minimize the NF, when the amplitude of a received signal is small, the BB VGA 125 mainly performs gain control of the received signal, and when the amplitude of a received signal is large, the RF LNA 105 mainly performs gain control of the received signal.

In conventional receiver systems, power of a received signal is measured, and power of I/Q signals output to the modem 150 is constantly controlled by controlling a gain of the BB VGA 125 if the power of the received signal is less than a split point or controlling a gain of the RF LNA 105 if the power of the received signal is greater than the split point. Control signals for controlling the gains of the RF LNA 105 and the BB VGA 125 are generated by the AGC 160, and the purpose of an operation of the AGC 160 is to minimize quantization noise due to analog-to-digital conversion and performance degradation due to saturation.

In general, a receiver system performs the operation described above. However, if a received signal of an antenna is too large, the problems described below may occur.

Since each analog amplification component has is limited by the voltage which can be output, saturation occurs in an output greater than the limitation, distorting a signal and generating second and third harmonics, resulting in a significant decrease of reception performance. Furthermore, since many interference signals having very large power exist in adjacent channels in a Ultra-High Frequency (UHF) band in which general broadcast channels exist, the possibility of decreased reception performance increases. In addition, if the AGC 160 is operated using a signal passing through the LPF/BPF 120 as in the structure of the conventional receiver system, a signal of an adjacent channel cannot be detected. Therefore, it is very difficult to prevent saturation of the amplification components, such as the RF LNA 105 and the BB VGA 125.

### SUMMARY OF THE INVENTION

An aspect of the present invention is to substantially solve at least the above problems and/or disadvantages and to provide at least the advantages below. Accordingly, an aspect of the present invention is to provide a method and apparatus for preventing saturation of an analog component using provided reception power when a Radio Frequency (RF) tuner of a wireless communication system provides reception power information in an output end of an RF Low Noise Amplifier (LNA) or a similar position.

Another aspect of the present invention is to provide a method and apparatus for preventing saturation of an analog component by performing Automatic Gain Control (AGC) using an output of a Power Detector (PD) in an RF tuner of a wireless communication system.

A further aspect of the present invention is to provide a method and apparatus for minimizing a Noise Figure (NF), maximizing RF sensitivity of a terminal, and minimizing power consumption within a range of preventing saturation of an amplification component in a receiver of a wireless communication system.

According to one aspect of the present invention, there is provided a gain change method of preventing saturation of an analog amplification component using reception signal information in a wireless communication system, the method including calculating power by digitizing a signal output from a Radio Frequency (RF) tuner, and receiving power obtaining by filtering a noise and fading effect; outputting a power detection value by detecting power from a signal obtained by low-noise-amplifying a received signal and digitizing the detected power; receiving an RF offset and a base-band offset pre-defined according to the power detection value; and controlling a gain using a Low Noise Amplifier (LNA) gain control signal and a Variable Gain Amplifier (VGA) gain control signal output by compensating the power obtaining by filtering for the RF offset and the base-band offset.

According to another aspect of the present invention, there is provided a gain change apparatus of preventing saturation of an analog amplification component using reception signal information in a wireless communication system, the apparatus including a gain offset compensator for outputting a power detection value by detecting power from a signal obtained by low-noise-amplifying a signal received to a Radio Frequency (RF) tuner and digitizing the detected power, and receiving an RF offset and a base-band offset pre-defined according to the power detection value; and an Automatic Gain Controller (AGC) for calculating power by digitizing a signal output from the RF tuner, receiving power obtaining by filtering a noise and fading effect, and controlling a gain by outputting a Low Noise Amplifier (LNA) gain control signal and a Variable Gain Amplifier (VGA) gain control signal obtained by compensating the power obtaining by filtering for the RF offset and the base-band offset.

### BRIEF DESCRIPTION OF THE DRAWINGS

The above and other objects, features and advantages of the present invention will become more apparent from the following detailed description when taken in conjunction with the accompanying drawing in which:
FIG. 1 is a block diagram of a conventional receiver system including a Direct Current (DC) offset canceller;
FIG 2 is a graph for describing linear gain control of a conventional Radio Frequency/Base-Band (RF/BB) amplifier;
FIG. 3 is a block diagram of a receiver system according to an exemplary embodiment of the present invention;
FIG 4 is a block diagram of an Automatic Gain Controller (AGC) according to an exemplary embodiment of the present invention;
FIG 5 diagrams a gain decision block according to an exemplary embodiment of the present invention;
FIG 6 is a block diagram of a gain offset compensator according to an exemplary embodiment of the present invention;
FIG. 7 is a graph for describing the operational principle of a gain offset compensator according to an exemplary embodiment of the present invention;
FIG 8 is a flowchart illustrating an operational process of a gain offset compensator according to an exemplary embodiment of the present invention; and
FIG 9 is a graph describing linear gain control of an RF Low Noise Amplifier (LNA) and a BB Variable Gain Amplifier (VGA) according to an exemplary embodiment of the present invention.

### DETAILED DESCRIPTION OF THE PREFERRED EMBODIMENTS

Preferred embodiments of the present invention will be described herein below with reference to the accompanying drawings. In the following description, well-known functions or constructions are not described in detail since they would obscure the invention in unnecessary detail. However, the terminology described below is defined considering functions in the present invention and may vary according to an intention or precedent of a user or operator. Thus, the definitions should be understood based on all the contents of the specification.

As described above in regard to conventional systems, if automatic gain control is performed using a signal passing through a Low Pass Filter (LPF) or Band Pass Filter (BPF) in a receiver, a signal of an adjacent channel cannot be detected. Thus, it is very difficult to prevent saturation of an amplification component. In order to make up for the disadvantage of the receiver, a Power Detector (PD) for detecting power of a received signal before the received signal passes through the LPF or BPF is included in a Radio Frequency (RF) tuner of a receiver of the present invention.

As described above, the performance degradation due to saturation of an analog component is fatal in communication, and a receiver according to an exemplary embodiment of the present invention includes a PD for providing power information of an output end of an RF Low Noise Amplifier (LNA) to a modem in order to prevent the performance degradation due to the saturation. Thus, an algorithm for preventing saturation of an analog component using power information detected by the PD is embedded in the RF tuner or the modem. However, an Automatic Gain Controller (AGC) operation algorithm using the PD has not been suggested or disclosed in conventional systems. Thus, in the present invention described below, an apparatus and method for preventing saturation of an amplification component and performing automatic gain control using the PD.

The present invention suggests a method of preventing saturation of an analog component by performing AGC using a PD output value of an RF tuner. Basically, if the PD output value increases, the increase of the PD output value is detected and saturation is prevented by decreasing a gain of an RF LNA. In this case, in order to uniformly maintain the total gain, a gain of a Base-Band Variable Gain Amplifier (BB VGA) is increased, as well as the decrease of the gain of the RF LNA. However, even in systems having the same total gain, since a Noise Figure (NF) is lower when the gain of the RF LNA is high than when the gain of the RF LNA is low, the gain of the RF LNA must be maximized if possible in order to increase the performance. Thus, in the present invention, a method of minimizing the NF within a range of preventing saturation of an amplification component, maximizing RF sensitivity of a mobile terminal, and minimizing power consumption is suggested.

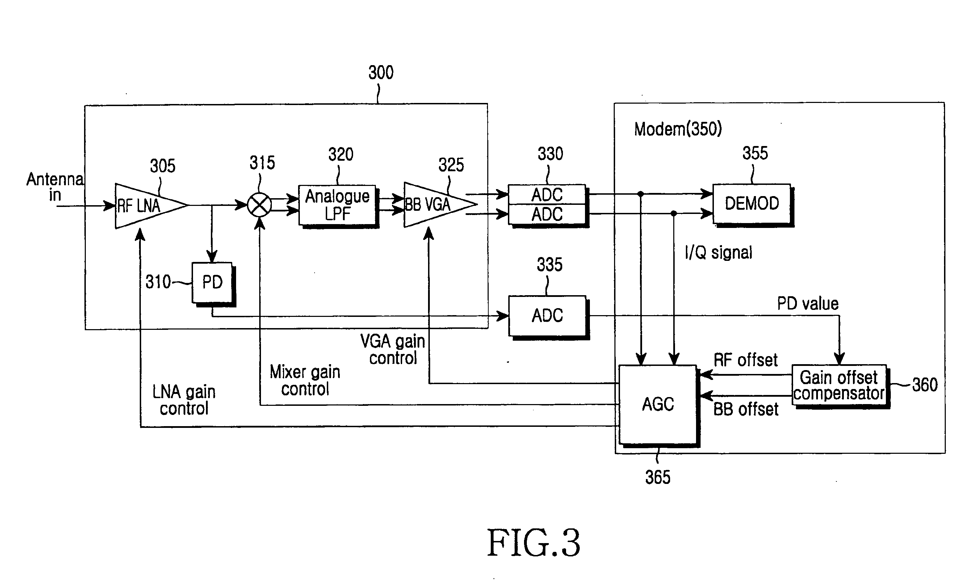

FIG 3 is a block diagram of a receiver system according to an exemplary embodiment of the present invention. The receiver system includes an RF tuner 300 and a modem 350, wherein a signal received via an antenna is amplified by an RF LNA 305 and input to a mixer 315, and a PD 310 detects power from a signal input to the mixer 315.

The mixer 315 down-converts the input signal, and an LPF or BPF 320 filters the signal down-converted by the mixer 315 and output the filtered signal to a BB VGA 325. The RF LNA 305 and the mixer 315 control a gain of a received signal based on a gain value input from an AGC 365 included in the modem 350, and the BB VGA 325 more accurately controls the gain approximately controlled by the RF LNA 305 and the mixer 315.
Control signals for controlling the gain of the received signal are generated by the modem 350. A signal output from the BB VGA 325 included in the RF tuner 300 is input to a demodulator 355 and the AGC 365 included in the modem 350 via a first Analog-to-Digital Converter (ADC) 330, and a signal output from the PD 310 is input to a gain offset compensator 360 via a second ADC 335 as a PD value.

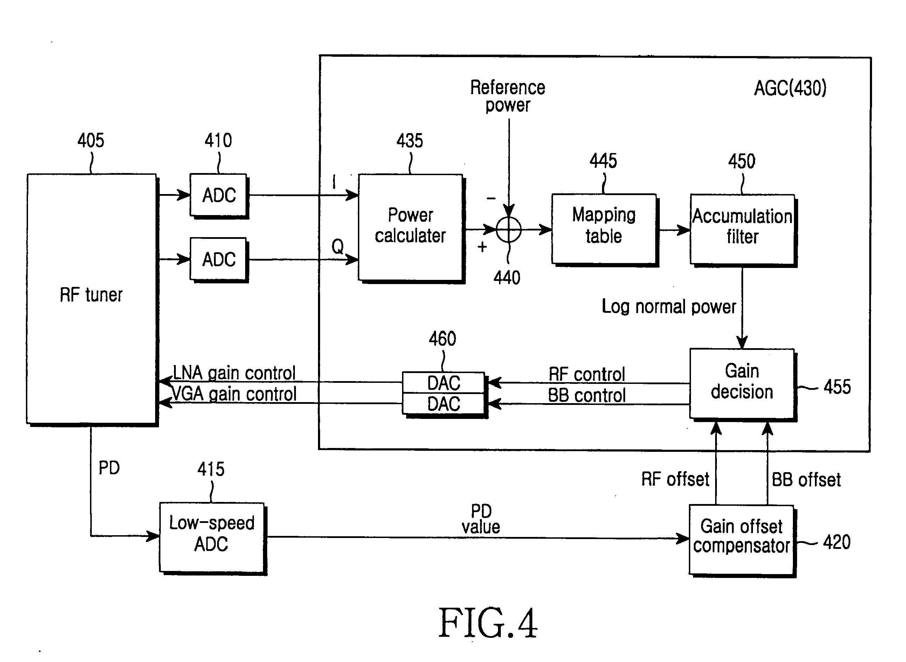

In particular, the gain offset compensator 360 and the AGC 365 included in the modem 350 will now be described in detail. The AGC 365 performs gain control of the RF LNA 305 and the BB VGA 325 by measuring power from received In-phase/Quadrature-phase (I/Q) signals, wherein saturation is prevented by additionally applying RF and BB offsets output from the gain offset compensator 360, which has received the PD value, to the gain control. The PD value is a signal digitized by passing the output of the PD 310 of the RF tuner 300 through the second ADC 335. The AGC 365 will now be described in detail with reference to FIG 4.

FIG 4 is a block diagram of the AGC 365 (430) according to an exemplary embodiment of the present invention. Referring to FIG 4, a signal output from an RF tuner 405 is output as an I signal and a Q signal by an ADC 410 and input to a power calculator 435 included in the AGC 430. The power calculator 435 performs power calculation, and an adder 440 subtracts a reference power signal from a signal output from the power calculator 435 and outputs the result to a mapping table 445. The mapping table 445 obtains received power and converts linear power to log-normal power, and an accumulation filter 450 outputs log-normal power, from which a noise and fading effect is reduced, to a obtain decision block 455.

The gain decision block 455 generates an RF control value and a BB control value using measured power, and, in the current embodiment, the gain decision block 455 decreases a gain of an RF LNA and simultaneously maintains the total gain constant by additionally compensating conventional RF and BB control signals for RF and BB offsets. The output RF and BB control signals are converted to analog signals by a Digital-to-Analog Converter (DAC) 460. The DAC 460 converts the RF control signal to an LNA gain control signal and the BB control signal to a VGA gain control signal and outputs the LNA gain control signal and the VGA gain control signal to the RF tuner 405.

The RF and BB offsets are output from a gain offset compensator 420, which has received a PD value output from a low-speed ADC 415 digitizing a PD signal output from the RF tuner 405.

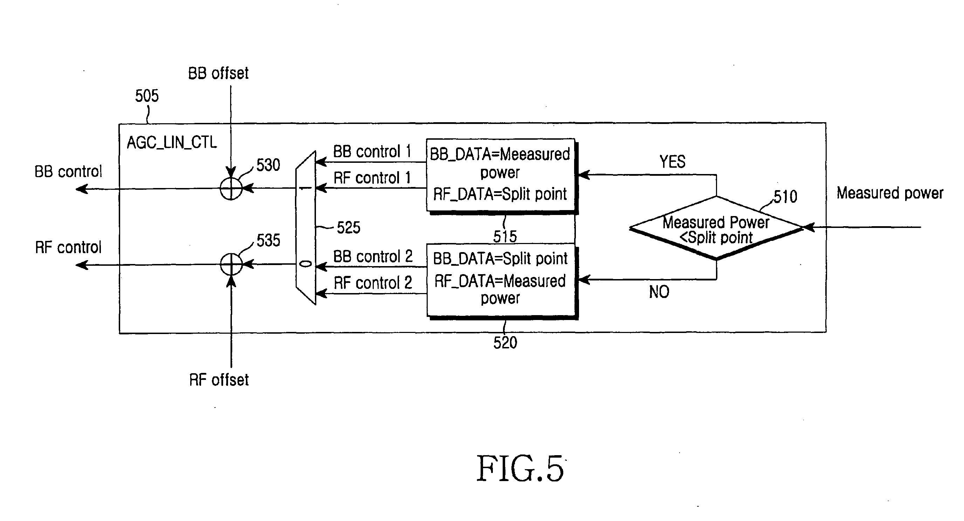

FIG 5 diagrams the gain decision block 455 (505) according to an exemplary embodiment of the present invention. FIG. 5 shows a gain decision operation in an AGC block, and, if the gain decision block 505 receives measured power, the gain decision block 505 determines in step 510 whether the measured power is less than a pre-set split point. If it is determined in step 510 that the measured power is less than the pre-set split point, the measured power is set as BB data and the split point is set as RF data in step 515, and a first BB control signal containing the BB data and a first RF control signal containing the RF data are input to a selector 525. If it is determined in step 510 that the measured power is greater than the pre-set split point, the split point is set as BB data and the measured power is set as RF data in step 520, and a second BB control signal containing the BB data and a second RF control signal containing the RF data are input to the selector 525.

The selector 525 receives the first BB and RF control signals and the second BB and RF control signals, and when a signal value of the selector 525 is selected as "1 ", the selector 525 outputs the first BB and RF control signals to an adder 530. The adder 530 outputs a BB control signal obtained by adding the first BB and RF control signals input from the selector 525 and the BB offset input from the gain offset compensator 420. When the signal value of the selector 525 is selected as "0", the selector 525 outputs the second BB and RF control signals to an adder 535. The adder 535 outputs an RF control signal obtained by adding the second BB and RF control signals input from the selector 525 and the RF offset input from the gain offset compensator 420. Thus, in the current embodiment, it is important to optimize the RF and BB offsets output from the gain offset compensator 420. The selector 525 outputs the first BB and RF control signals generated in step 515 or the second BB and RF control signals generated in step 520 according to the comparison result in step 510.

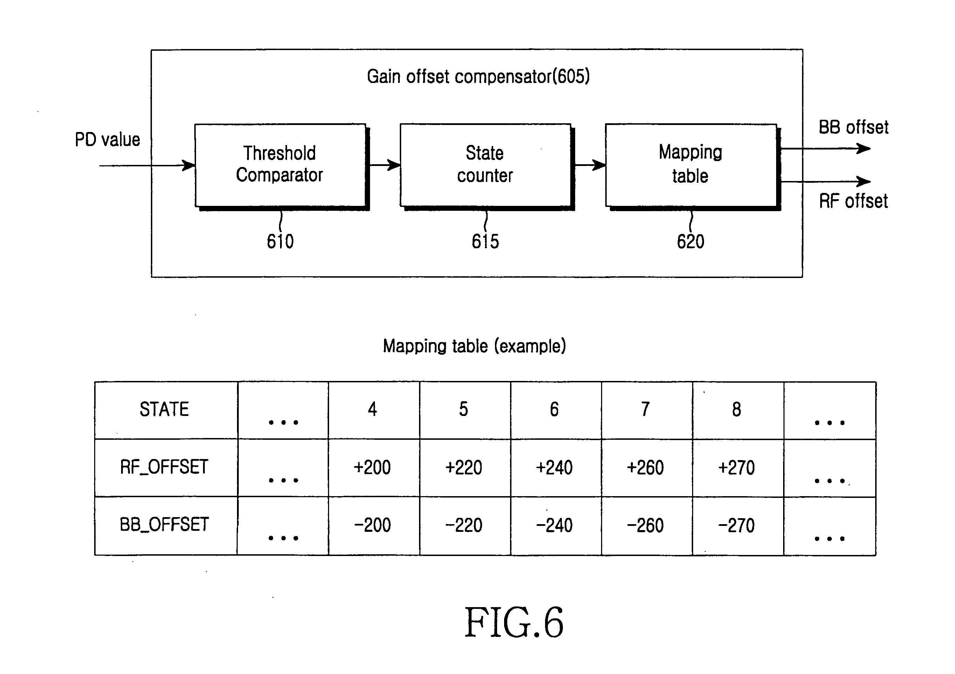

FIG 6 is a block diagram of the gain offset compensator 605 360 and 420 in FIGS. 3 and 4, respectively according to an exemplary embodiment of the present invention. In order to support the gain decision illustrated in FIG 5, in the gain offset compensator 605, a threshold comparator 610 compares an input PD value with rise and fall thresholds, a state counter 615 increases or decreases a state value using the comparison result of the PD value and the rise or fall threshold and outputs the determined state value to a mapping table 620, and the mapping table 620 outputs RF and BB offsets according to the determined state value.

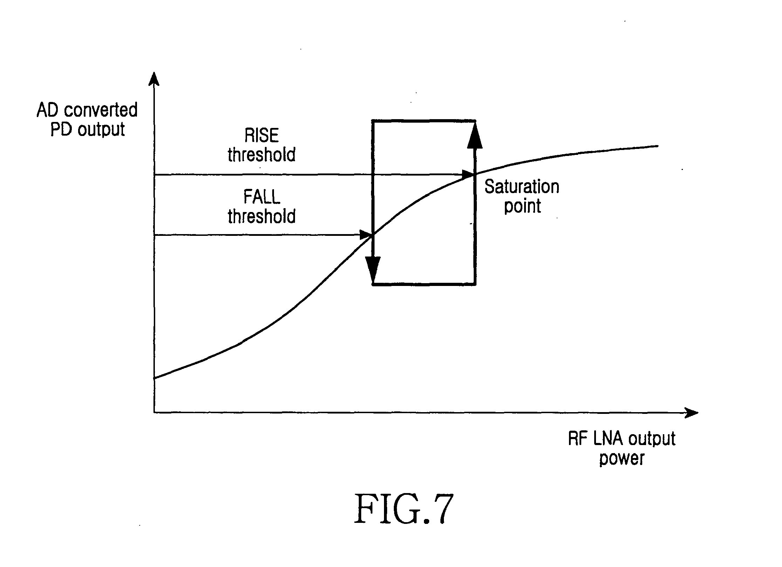

In the mapping table 620, RF offset and BB offset values according to state values are pre-defined as illustrated in FIG 6, and RF and BB offsets according to a determined state value are output. The rise and fall thresholds will be described in detail with reference to FIG 7. FIG 6 shows that as a state value increases, an offset for increasing a gain of the RF LNA 305 and an offset for decreasing a gain of the BB VGA 325 are mapped to the state value. However, unlike the example of the mapping table 620 of FIG 6, as a state value increases, an offset for decreasing a gain of the RF LNA 305 and an offset for increasing a gain of the BB VGA 325 may be mapped to the state value.

FIG. 7 is a graph for describing the operational principle of the gain offset compensator 360, 420, or 605 according to an exemplary embodiment of the present invention. In FIG 7, the rise threshold is determined as a point having the high occurrence possibility of saturation of an RF amplification component, and every time measured power exceeds the rise threshold, the state value is increased by 1. The fall threshold is determined as a stable point, and every time measured power is less than the fall threshold, the state value is decreased by 1. Since a high state value indicates that output power of the RF LNA 305 is high, there is a high saturation possibility. Thus, as the state valueincreases, the gain of the RF LNA 305 is decreases and the gain of the BB VGA 325 is increases. Thus, if the gain offset compensator 360, 420, or 605 operates normally, the entire system forms a loop, fixing the state value to an appropriate value. Although it has been described in FIG 7 that the state value increases or decreases by 1, the increased or decreased amount can be changed according to implementation of a system, and thus, the increased or decreased amount of the state value is called a predetermined value.

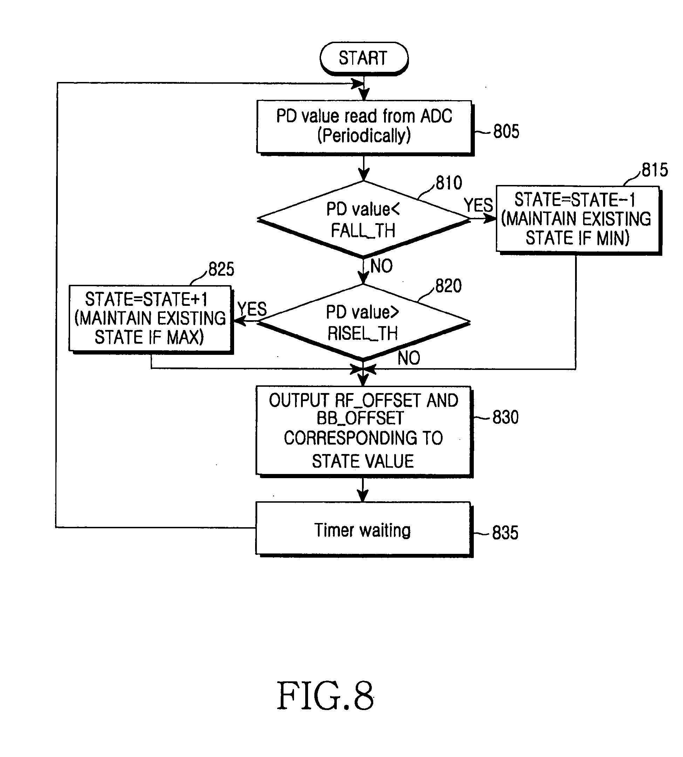

FIG 8 is a flowchart illustrating an operational process of the gain offset compensator 360 (420 and 605) according to an exemplary embodiment of the present invention.

As described above, a PD value is a digital value obtained by ADC-converting a PD output provided by the RF tuner 300, and the gain offset compensator 360 (420 and 605) periodically reflects the PD value using a timer expiring after a predetermined time elapses instead of immediately reading the PD value. If the period of the timer is set long, deviation due to a temporary noise or fading channel effect, which can occur in an actual reception environment, can be minimized. However, if it is desired to prevent even saturation of an amplification component due to this temporary change, the period of the timer may be set very short, as optimally set according to a development situation.

The gain offset compensator 360 (420and 605) periodically reads a PD value from the ADC 335 (415) in step 805. If it is determined in step 810 that the PD value read in step 805 is less than the fall threshold, the state value is decreased in step 815, and the process proceeds to step 830. If it is determined in step 810 that the PD value read in step 805 is not less than the fall threshold, the gain offset compensator 360 (420and 605) determines in step 820 whether the PD value is greater than the rise threshold. If it is determined in step 820 that the PD value is greater than the rise threshold, the state value is increased in step 825 and the process proceeds to step 830. If it is determined in step 820 that the PD value is not greater than the rise threshold, the mapping table 620 outputs RF and BB offsets corresponding to the state value in step 830. The gain offset compensator 360 (420and 605) waits in step 835 until the timer expires. In the process, if the PD value is the minimum value in step 815, the state value is not decreased. If the PD value is the maximum value in step 825, the state value is not increased. In addition, if the PD value is between the fall threshold and the rise threshold, the state value is not changed, and the gain offset compensator 360 (420and 605) waits until the timer expires. Of course, the mapping table 620 continuously outputs RF and BB offsets corresponding to the state value.

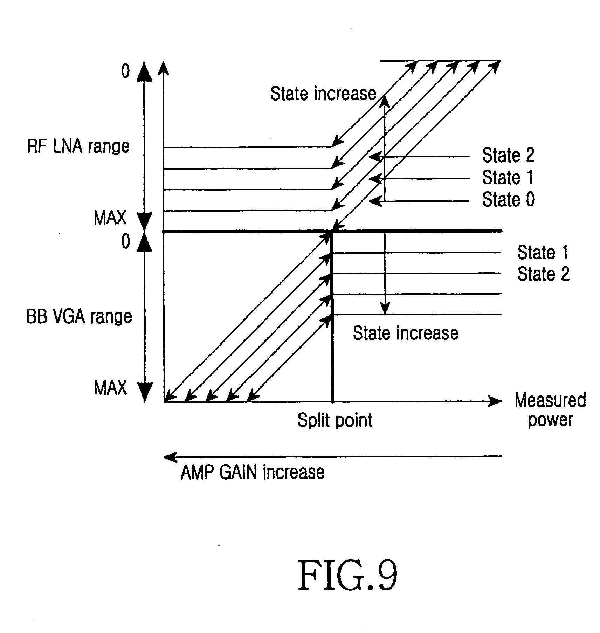

FIG. 9 is a graph for describing linear gain control of the RF LNA 305 and the BB VGA 325 according to an exemplary embodiment of the present invention. Referring to FIG 9, if a state value is increased, a gain is decreased in an RF LNA range, and a gain is increased in a BB VGA range.

FIG 9 shows the entire RF LNA and BB VGA gain control operation of the AGC 365 (430), and, compared to FIG. 2, the gain of the RF LNA 305 according to the state value is decreased. In addition, in FIG. 9, in an RF operation region in which measured power of a received signal is greater than a split point, the gain of the RF LNA 305 is adjusted according to a curve in the RF LNA range. On the other hand, in a BB operation region in which measured power of a received signal is less than the split point, the gain of the BB VGA 325 is adjusted according to a curve in the BB VGA range.

In FIG. 9, a gain control curve of the RF LNA 305 moves parallel in the RF operation region, and an originally set fixed gain of the RF LNA 305 is decreased in the BB operation region. On the other hand, a fixed gain of the BB VGA 325 is increased in the RF operation region, and a gain control curve of the BB VGA 325 parallel moves in the BB operation region. In any case, a dynamic range of a received signal can be continuously covered. In addition, the NF is minimized by decreasing the RF LNA gain by only a necessary amount according to each state value.

As described above, according to the present invention, in an environment in which a large adjacent channel interference signal exists, saturation of an RF amplification component can be prevented. As a result, since a cheaper amplification component can be used, the terminal implementation cost can be reduced, and since a wider coverage can be obtained even with limited transmission power, network construction cost can be significantly reduced. In addition, since additional blocks can be implemented with very simple hardware, an efficient modem design can be attained.

While the invention has been shown and described with reference to a certain preferred embodiment thereof, it will be understood by those skilled in the art that various changes in form and details may be made therein without departing from the spirit and scope of the invention as defined by the appended claims.

## Claims

1. A method of controlling a gain of a received signal in a receiver using a Low Noise Amplifier (LNA) and a Variable Gain Amplifier (VGA), the method comprising:
respectively generating first gain control signals for the LNA and the VGA based on a signal received via an antenna and digitized by the LNA and the VGA;
measuring a power detection value from power of a low-noise-amplified signal by the LNA;
determining offsets for controlling increase and decrease of the first gain control signals based on the power detection value of the LNA output; and
respectively providing second gain control signals obtained by adding the offsets to the first gain control signals to the LNA and the VGA.

2. The method of claim 1, the determining the offsets comprises:
comparing the power detection value with a pre-set threshold and determining a state value for selecting the offsets according to the comparison result; and
outputting offsets mapped to the determined state value.

3. The method of claim 2, the comparing the power detection value with the pre-set threshold and the determining of the state value for selecting the offsets according to the comparison result comprises:
comparing the power detection value with a pre-set rise threshold and a pre-set fall threshold; and
if the power detection value is greater than the rise threshold, increasing the state value, and if the power detection value is less than the fall threshold, decreasing the state value.

4. The method of claim 2, wherein outputting offsets mapped to the determined state value comprises, if the determined state value is increased, outputting a first offset for increasing gain of the VGA and outputting a second offset for decreasing gain of the LNA.

5. The method of claim 2, wherein outputting offsets mapped to the determined state value comprises, if the determined state value is decreased, outputting a first offset for decreasing gain of the VGA and outputting a second offset for increasing gain of the LNA.

6. The method of claim 4, wherein the first offset is added to the first gain control signal for controlling the gain of the VGA, and the second offset is added to the first gain control signal for controlling the gain of the LNA.

7. An apparatus for controlling a gain of a received signal using a Low Noise Amplifier (LNA) and a Variable Gain Amplifier (VGA) in a receiver, the apparatus comprising:
a power detector for measuring a power detection value from an output the LNA;
a gain offset compensator for outputting offsets for controlling increase and decrease of first gain control signals for controlling gains of the LNA and the VGA based on a signal received via an antenna and digitized by the LNA and the VGA, and
an Automatic Gain Controller (AGC) for respectively generating the first gain control signals for controlling the gains of the LNA and the VGA based on power of a signal received by the receiver and respectively providing second gain control signals obtained by adding the offsets to the first gain control signals to the LNA and the VGA.

8. The apparatus of claim 7, wherein the gain offset compensator determines a state value for selecting the offsets by comparing the power detection value with a pre-set threshold and outputs offsets mapped to the determined state value.

9. The apparatus of claim 8, wherein the gain offset compensator compares the power detection value with a pre-set rise threshold and a pre-set fall threshold, and increases the state value if the power detection value is greater than the rise threshold, and decreases the state value if the power detection value is less than the fall threshold.

10. The apparatus of claim 8, wherein if the determined state value increases, the gain offset compensator outputs a first offset for increasing the gain of the VGA and outputs a second offset for decreasing the gain of the LNA.

11. The apparatus of claim 8, wherein if the determined state value decreases, the gain offset compensator outputs a first offset for decreasing the gain of the VGA and outputs a second offset for increasing the gain of the LNA.

12. The apparatus of claim 10, wherein the AGC adds the first offset to the first gain control signal for controlling the gain of the VGA and adds the second offset to the first gain control signal for controlling the gain of the LNA.
